# EUROPEAN PATENT SPECIFICATION

(11) **EP 2 580 861 B1**
(45) Date of publication and mention of the grant of the patent: **29.04.2015**
(21) Application number: 10852820.9
(22) Date of filing: 09.06.2010
(51) Int. Cl.: H03F 3/04, H01L 23/50, H01L 23/00, H03F 3/189, H03F 1/56

(54) **INTEGRATED CIRCUIT INCLUDING A DIFFERENTIAL POWER AMPLIFIER WITH A SINGLE ENDED OUTPUT AND AN INTEGRATED BALUN**
INTEGRIERTER SCHALTKREIS MIT EINEM DIFFERENZIALLEISTUNGSVERSTÄRKER MIT SINGLE-ENDED-AUSGANG UND INTEGRIERTEM BALUN
CIRCUIT INTÉGRÉ COMPRENANT UN AMPLIFICATEUR DE PUISSANCE DIFFÉRENTIEL DOTÉ D'UNE SORTIE NON ÉQUILIBRÉE ET D'UN SYMÉTRISEUR D'ANTENNE INTÉGRÉ

(43) Date of publication of application: 17.04.2013
(73) Proprietor: DSP Group Ltd., 46120 Herzelia (IL)
(72) Inventor: GENIK, Anatoly, 44400 Kfar Saba (IL); MOSTOV, Alex, 75470 Rishon Le Zion (IL)
(74) Representative: Modiano, Micaela Nadia
(86) International application number: PCT/IL2010/000459
(87) International publication number: WO 2011/154931

(56) References cited:
- US-A- 3 936 864
- US-A- 4 891 686
- US-A- 5 371 405
- US-A1- 2002 134 993
- US-A1- 2005 040 896
- US-A1- 2005 206 471
- US-A1- 2005 208 901
- US-A1- 2006 084 392
- US-A1- 2007 026 834
- US-B1- 6 646 343
- US-B1- 7 091 791
- BAKASKI W ET AL: "A fully integrated 4.8-6 GHz power amplifier with on-chip output balun in 38 GHz-fT Si-bipolar", 2003 IEEE MTT-S INTERNATIONAL MICROWAVE SYMPOSIUM DIGEST.(IMS 2003). PHILADELPHIA, PA, JUNE 8 - 13, 2003; [IEEE MTT-S INTERNATIONAL MICROWAVE SYMPOSIUM], NEW YORK, NY : IEEE, US, vol. 2, 8 June 2003 (2003-06-08), pages 695-698, XP010645003, DOI: 10.1109/MWSYM.2003.1212467 ISBN: 978-0-7803-7695-3
- BAKALSKI W ET AL: "Lumped and distributed lattice-type LC-baluns", 2002 IEEE MTT-S INTERNATIONAL MICROWAVE SYMPOSIUM DIGEST (CAT. NO.02CH37278) IEEE PISCATAWAY, NJ, USA; [IEEE MTT-S INTERNATIONAL MICROWAVE SYMPOSIUM], IEEE, 2 June 2002 (2002-06-02), pages 209-212vol.1, XP032408232, DOI: 10.1109/MWSYM.2002.1011595 ISBN: 978-0-7803-7239-9
- FRITZIN J ET AL: "Impedance Matching Techniques in 65nm CMOS Power Amplifiers for 2.4GHz 802.11n WLAN", MICROWAVE CONFERENCE, 2008. EUMC 2008. 38TH EUROPEAN, IEEE, PISCATAWAY, NJ, USA, 27 October 2008 (2008-10-27), pages 1207-1210, XP031407384, ISBN: 978-2-87487-006-4
- BAKALSKI W ET AL: "A Fully Integrated 5.3-GHz 2.4-V 0.3-W SiGe Bipolar Power Amplifier With 50-<tex>$Omega $</tex>Output", IEEE JOURNAL OF SOLID-STATE CIRCUITS, IEEE SERVICE CENTER, PISCATAWAY, NJ, USA, vol. 39, no. 7, 1 July 2004 (2004-07-01), pages 1006-1014, XP011114645, ISSN: 0018-9200, DOI: 10.1109/JSSC.2004.829967
- BAKALSKI W ET AL: "A fully integrated 5.3 GHz, 2.4 V, 0.3 W SiGe-bipolar power amplifier with 50 /spl Omega/ output", EUROPEAN SOLID-STATE CIRCUITS, 2003. ESSCIRC '03. CONFERENCE ON 16-18 SEPT. 2003, PISCATAWAY, NJ, USA,IEEE, 16 September 2003 (2003-09-16), pages 561-564, XP010677228, DOI: 10.1109/ESSCIRC.2003.1257197 ISBN: 978-0-7803-7995-4

## Description

### FIELD OF THE INVENTION

The present invention relates generally to an integrated circuit including a differential power amplifier with a single ended output embedded therein and more specifically wherein the integrated circuit package includes an integrated BALUN to provide the single ended output.

### BACKGROUND OF THE INVENTION

Many integrated circuit designers use differential amplifiers to improve the amplification quality in integrated circuits. The differential amplifiers allow stronger amplification without adding unnecessary noise to the integrated circuit.

One drawback is that differential amplifiers produce two output signals which have a phase shift between them so that they cannot be directly combined to form a single ended output without first bringing the two output signals into alignment. The alignment of the output signals requires use of a converter that converts balanced input to unbalanced output or vice versa, and is generally referred to as a BALUN. Use of a BALUN converter on the die of the integrated circuit would waste valuable space. One known type of converter uses transformers to align the output signals from the differential amplifier. Another type of converter uses a circuit including capacitors and inductors (e.g. a coil) to align the signals. In either case the converter wastes valuable space on the die of the integrated circuit unless the integrated circuit does not combine the outputs of the differential amplifier and leaves it to elements external to the integrated circuit to combine the signals. However, board designers generally prefer integrated circuits that provide the final result in contrast to integrated circuits that leave it up to the board designer to provide the required missing elements for designing an electronic device.

US patent no. 7,592,872 to El Rai dated September 22, 2009 describes a differential amplifier with a single ended output by forming a converter circuit in an integrated circuit.

US patent no. 7091 791 describes the use of magnetic coupling between bending wires to transform a differential signal to a single ended signal.

### SUMMARY OF THE INVENTION

An aspect of an embodiment of the invention, relates to a differential power amplifier with a single ended output embedded in an integrated circuit. The output of the amplifier is converted using a BALUN converter that includes capacitors and inductors. The inductors are implemented by using the inherent inductance of the bond wires that connect between the integrated circuit die and the contact pins located in the encasement protecting the die that interface between the integrated circuit and external elements. Optionally, the capacitors of the converter are embedded in the die and connected to the outputs of the differential power amplifier.

In an exemplary embodiment of the invention, the inductance of the wires is controlled by their length and thickness. Optionally, the length of the wires is extended by offsetting the position of contact to the die or the position of the contact pin on the integrated circuit encasement. In an exemplary embodiment of the invention, the wires are not connected to the nearest contact pin, but rather to a contact pin that optimizes the level of inductance of the wires. In some embodiments of the invention, the die is offset from the center of the encasement and positioned closer to one side of the encasement to optimize the level of inductance of the wires. In some embodiments of the invention, additional wires are connected between the same point on the die and the same output pin to form a parallel inductor and thereby reduce the inductance to a specific pin. In some embodiments of the invention, each wire may have a different thickness to provide an optimal level of inductance.

There is thus provided according to an exemplary embodiment of the invention an integrated circuit, including:
A die with an electronic circuit embedded thereon; wherein the electronic circuit includes a differential power amplifier and pads to electronically interface with the electronic circuit;
A packaging encasing the die with contact pins to connect between the integrated circuit and external elements;
Wires connecting between the pads and the contact pins;
A converter that includes capacitors and inductors to combine the outputs from the differential power amplifier to form a single ended output at one of the contact pins; wherein inherent inductance of some of the wires serve as the inductors of the converter.

In an exemplary embodiment of the invention, the capacitors are embedded on the die between the differential power amplifier and the pads. Optionally, the die is positioned in the packaging so that the length of the wires will be optimized to provide inductance for the converter. In an exemplary embodiment of the invention, the position of some of the pads on the die or the contact pins on the packaging are offset to cause the wires connecting between them to be extended or shortened. Optionally, the designation of the contact pins used to connect to the differential power amplifier are selected so that the length of the wires will optimally provide inductance to the converter. In an exemplary embodiment of the invention, the thicknesses of the wires used to connect to the contacts of the differential power amplifier are selected to optimally provide inductance to the converter. Optionally, the trajectories of the wires used to connect to the contacts of the differential power amplifier are raised or lowered to optimally provide inductance to the converter. In an exemplary embodiment of the invention, multiple wires connect between a specific pad and pin of the contacts of the differential power amplifier to alter the inductance between the pad and the pin by forming multiple inductors in parallel.

There is further provided according to an exemplary embodiment of the invention, a method of converting the output of a differential power amplifier embedded on the die of an integrated circuit to a single ended output, comprising:
Positioning pads on the die to electronically interface with the electronic circuit on the die;
Forming a packaging to encase the die, wherein the packaging includes contact pins to connect the integrated circuit to external elements;
Connecting wires between the pads and contact pins serving as the contacts of the differential power amplifier;
Combining the outputs of the differential power amplifier using capacitors and inductors; wherein the inductors are provided by the wires connecting between the pads and the pins.

In an exemplary embodiment of the invention, the capacitors are embedded on the die between the differential power amplifier and the pads.

### BRIEF DESCRIPTION OF THE DRAWINGS

The present invention will be understood and better appreciated from the following detailed description taken in conjunction with the drawings. Identical structures, elements or parts, which appear in more than one figure, are generally labeled with the same or similar number in all the figures in which they appear, wherein:
Fig. 1A is a schematic illustration of an integrated circuit with a differential amplifier, according to an exemplary embodiment of the invention;
Fig. 1B is a schematic illustration of the electronic circuit layout of an integrated BALUN as implemented by Fig. 1A, according to an exemplary embodiment of the invention;
Fig. 2A is a schematic illustration of a cross sectional side view of an integrated circuit, according to an exemplary embodiment of the invention;
Fig. 2B is a schematic illustration of a top view of an integrated circuit, according to an exemplary embodiment of the invention; and
Fig. 3 is a schematic illustration of a top view of a variation of an integrated circuit, according to an exemplary embodiment of the invention.

### DETAILED DESCRIPTION

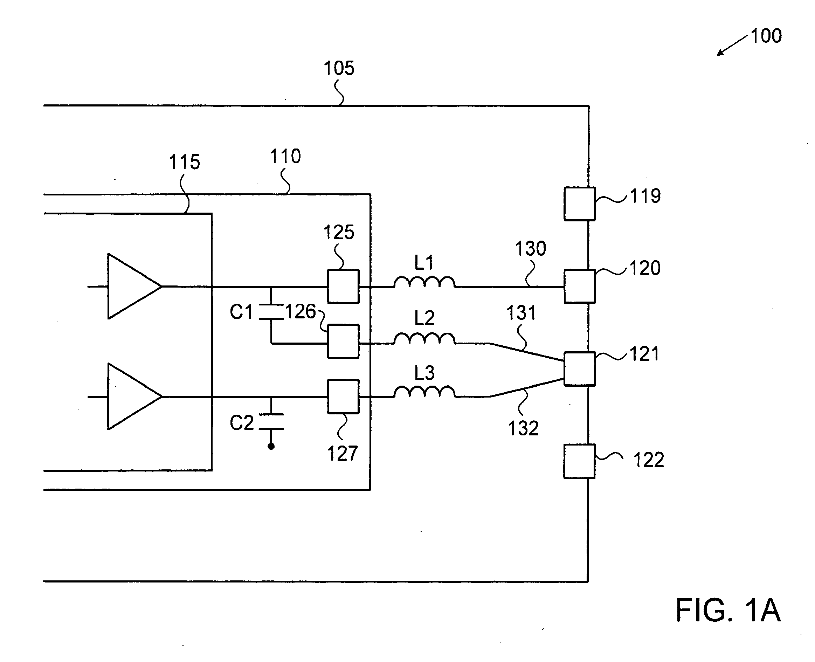

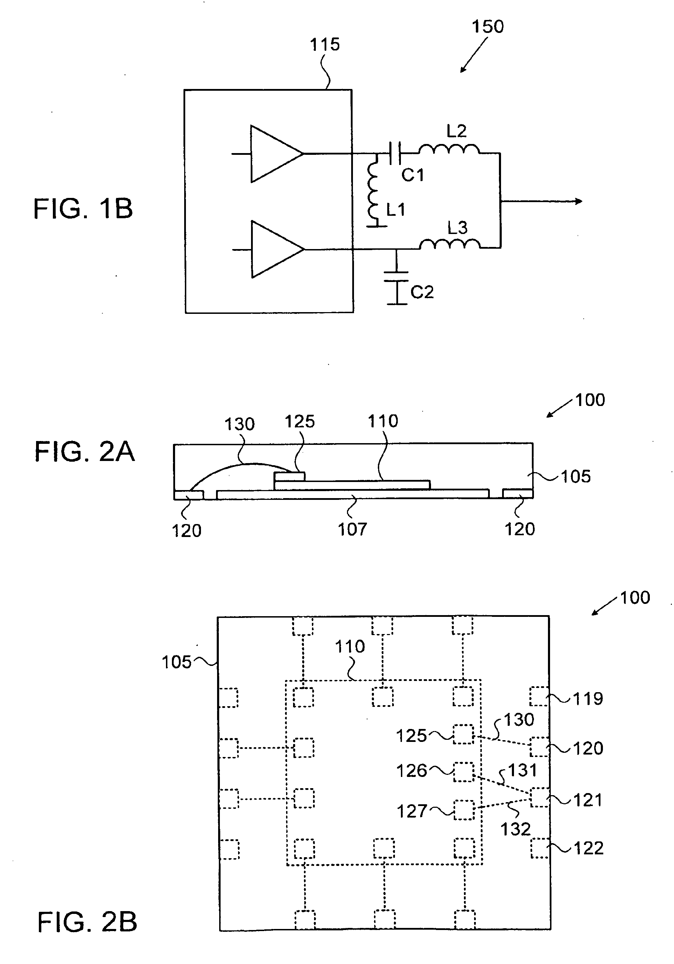

Fig. 1A is a schematic illustration of an integrated circuit 100 with a differential amplifier 115, and Fig. 1B is a schematic illustration of the electronic circuit layout of an integrated BALUN 150 as implemented by Fig. 1A, according to an exemplary embodiment of the invention. As shown in Fig. 1A integrated circuit 100 includes a die 110 with an electronic circuit embedded therein, the die including a differential amplifier 115. Optionally, integrated circuit 100 is placed on a metallic paddle 107 (shown in Fig. 2A) and encased by an integrated circuit (IC) package 105 (e.g. molded from plastic). In an exemplary embodiment of the invention, die 110 includes pads (e.g. 125, 126 and 127), which are positioned on the edges of die 110 to electrically connect between die 110 and contact pins (e.g. 120, 121 and 122) located on the bottom of IC package 105 for connecting the integrated circuit to external elements. Optionally, the contact pins (e.g. 120, 121 and 122) are originally part of paddle 107 and they are formed by cutting away an inner circumference from paddle 107 leaving the pins (e.g. 120, 121 and 122) isolated. Optionally, the connections between pads (e.g. 125, 126 and 127) and pins (e.g. 120, 121 and 122) are implemented by bond wires (e.g. 130, 131 and 132).

In an exemplary embodiment of the invention, the outputs of differential amplifier 115 are connected to BALUN 150, which is made up from capacitors and inductors as shown in the design of Fig. 1B. In an exemplary embodiment of the invention, the capacitors of BALUN 150 are implemented on die 110 whereas the inductors are implemented by exploiting the inherent inductance of the wires (130, 131, and 132) that connect between pads (125, 126, 127) and contact pins (120, 121, 122). Typically, wires (130, 131, 132) are thicker than the connections on die 110, for example with a thickness of about 20µm for wires (130, 131, 132) relative to about 2µm for connections internal to die 110. The extra thickness lowers resistance and reduces power loss. (130, 131, 132). The inductance is a function of the thickness and the length of the wire. The parasitic inductance generally interferes with the output of integrated circuits that function with high frequency/RF signals, whereas low frequency signals and DC signals are essentially not affected by the parasitic inductance. In an exemplary embodiment of the invention, inductor L1 of BALUN 150 is implemented by wire 130, inductor L2 is implemented by wire 131 and inductor L3 is implemented by wire 132. Wires 131 and 132 are both connected to pin 121 of integrated circuit 100 and wire 130 is connected to pin 120, which serves as a VCC input for BALUN 150.

Fig. 2A is a schematic illustration of a side cross sectional view of integrated circuit 100 and Fig. 2B is a schematic illustration of a top view of integrated circuit 100, according to an exemplary embodiment of the invention. In some embodiments of the invention the position of pins 120 and 121 may be offset relative to pads 125, 126 and 127 so that longer or shorter connecting wires 130, 131 and 132 will be used to increase or reduce the inductance of inductors L1, L2 and L3 as required for the design of BALUN 150. Alternatively or additionally, pads 125, 126 and 127 may be intentionally wired to pins that are further away (e.g. 119 and 122) so that the length of the wires will be increased. Optionally, thicker or thinner wires may be used for one or more of the connecting wires (130, 131, 132) to increase or reduce the inductance of the wires. In some embodiments of the invention, the trajectory of wires (130, 131, 132) (e.g. as shown in Fig. 2A for wire 130) is raised or lowered so that wires (130, 131, 132) will be longer or shorter thus increasing or decreasing their inductance.

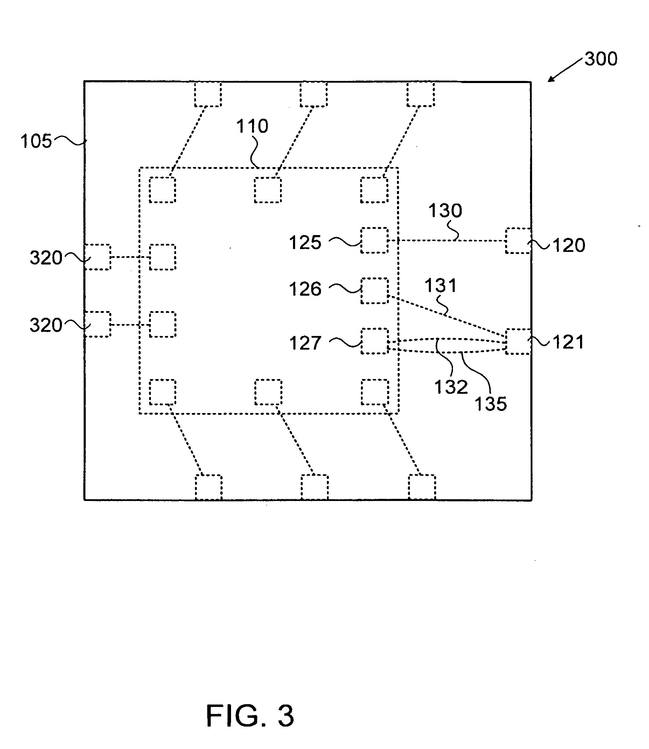

Fig. 3 is a schematic illustration of a top view of a variation of integrated circuit 100, according to an exemplary embodiment of the invention. In an exemplary embodiment of the invention, an integrated circuit 300 is designed wherein die 110 is offset from the center of IC package 105, for example positioned more to one side than the other. Optionally, this allows two benefits:
1. Reducing the parasitic inductance for the outputs 320 of the integrated circuit on the side that does not include a differential amplifier 115;
2. Increasing the inductance of wires 130, 131, 132 so that the positioning of the die 110 can be used to increase or reduce the inductance to a desired value.

In some embodiments of the invention, one or more of wires 130, 131 and 132 may be implemented by multiple wires in parallel (e.g. 132 and 135) to control the total inductance between the pads (125, 126, 127) and the contact pins (120, 121, 122). In Fig. 3, wire 132 is provided with a parallel wire 135 to reduce the total inductance between pad 127 and pin 121.

It should be appreciated that the above described methods and apparatus may be varied in many ways, including omitting or adding steps, changing the order of steps and the type of devices used. It should be appreciated that different features may be combined in different ways. In particular, not all the features shown above in a particular embodiment are necessary in every embodiment of the invention. Further combinations of the above features are also considered to be within the scope of some embodiments of the invention.

It will be appreciated by persons skilled in the art that the present invention is not limited to what has been particularly shown and described hereinabove. Rather the scope of the present invention is defined only by the claims, which follow.

## Claims

1. An integrated circuit (100), comprising:
a die with an electronic circuit embedded thereon; wherein the electronic circuit includes a differential power amplifier (115) and pads (125, 126, 127) to electronically interface with the electronic circuit;
a packaging (105) encasing the die with contact pins (120, 121, 122) to connect between the integrated circuit and external elements;
wires (130, 131, 132) connecting between the pads (125, 126, 127) and the contact pins (120, 121, 122);
a converter (150) that includes capacitors and inductors to combine the output signals of the differential power amplifier to form a single ended output signal at one of the contact pins; wherein the capacitors are embedded on the die between the differential power amplifier and the pads;
wherein inherent inductance of some of the wires (130, 131, 132) serve as the inductors of the converter.

2. An integrated circuit (100) according to claim 1, wherein the die is offset from a center of the packaging.

3. An integrated circuit (100) according to claim 1, wherein the die is positioned in the packaging so that a length of the wires will be optimized to provide inductance for the converter.

4. An integrated circuit (100) according to claim 1, wherein a position of some of the pads on the die or the contact pins on the packaging are offset to cause the wires connecting between them to be extended or shortened.

5. An integrated circuit according to claim 1, wherein a designation of the contact pins used to connect to the differential power amplifier are selected so that a length of the wires will optimally provide inductance to the converter.

6. An integrated circuit according to claim 1, wherein a thickness of the wires used to connect to the contacts of the differential power amplifier is selected to optimally provide inductance to the converter.

7. An integrated circuit according to claim 1, wherein trajectories of the wires used to connect to the contacts of the differential power amplifier are raised or lowered to optimally provide inductance to the converter.

8. An integrated circuit according to claim 1, wherein multiple wires connect between a specific pad and a pin of the contacts of the differential power amplifier to alter an inductance between the pad and the pin by forming multiple inductors in parallel.

9. A method of converting the output of a differential power amplifier embedded on the die of an integrated circuit to a single ended output signal, comprising:
positioning pads on the die to electronically interface with the electronic circuit on the die;
forming a packaging to encase the die, wherein the packaging includes contact pins to connect the integrated circuit to external elements;
connecting wires between the pads and contact pins serving as the contacts of the differential power amplifier;
combining the output signals of the differential power amplifier using capacitors and inductors; wherein the capacitors are embedded on the die between the differential power amplifier and the pads;
wherein the inductors are provided by the wires connecting between the pads and the pins.

10. A method according to claim 9, wherein the die is offset from a center of the packaging.

11. A method according to claim 9, wherein the die is positioned in the packaging so that a length of the wires will be optimized to provide inductance for the converter.

12. A method according to claim 9, wherein the contact pins are formed in by cutting away an inner circumference of a metallic paddle (107) leaving the contact pins isolated; the integrated circuit is placed on the metallic paddle.

13. A method according to claim 9, wherein multiple wires connect between a specific pad and a pin of the contacts of the differential power amplifier to alter an inductance between the pad and the pin by forming multiple inductors in parallel.

14. A method according to claim 9, wherein trajectories of the wires used to connect to the contacts of the differential power amplifier are raised or lowered to optimally provide inductance to the converter.

15. An integrated circuit according to claim 1, wherein the contact pins are formed in by cutting away an inner circumference of a metallic paddle (107) leaving the contact pins isolated; the integrated circuit is placed on the metallic paddle.

## Patentansprüche

1. Ein integrierter Schaltkreis (100), der Folgendes umfasst:
einen Chip mit einer darin eingebetteten elektronischen Schaltung, wobei die elektronische Schaltung einen Differenz-Leistungsverstärker (115) und Kontaktflächen (125, 126, 127) zur elektronischen Verbindung mit der elektronischen Schaltung einschließt,
ein Gehäuse (150), das den Chip umhüllt, mit Kontaktstiften (120, 121, 122) zur Verbindung zwischen dem integrierten Schaltkreis und externen Elementen,
Drähte (130, 131, 132), die die Kontaktflächen (125, 126, 127) und die Kontaktstifte (120, 121, 122) verbinden,
einen Wandler (150), der Kondensatoren und Induktoren zur Kombination der Ausgangssignale des Differenz-Leistungsverstärker einschließt, um ein unsymmetrisches Ausgangssignal an einem der Kontaktstifte zu bilden, wobei die Kondensatoren zwischen dem Differenz-Leistungsverstärker und den Kontaktflächen in den Chip eingebettet sind,
wobei die inhärente Induktivität mancher Drähte (130, 131, 132) als Induktoren des Wandlers dient).

2. Ein integrierter Schaltkreis (100) gemäß Anspruch 1, worin der Chip von einer Mitte des Gehäuses versetzt ist.

3. Ein integrierter Schaltkreis (100) gemäß Anspruch 1, worin der Chip so in dem Gehäuse positioniert ist, dass eine Länge der Drähte optimiert wird, um Induktivität für den Wandler bereitzustellen.

4. Ein integrierter Schaltkreis (100) gemäß Anspruch 1, worin eine Position einiger der Kontaktflächen auf dem Chip oder der Kontaktstifte auf dem Gehäuse versetzt ist, um zu bewirken, dass die Drähte, die sie verbinden, verlängert oder verkürzt werden.

5. Ein integrierter Schaltkreis gemäß Anspruch 1, worin eine Kennzeichnung der Kontaktstifte, die zur Verbindung mit dem Differenz-Leistungsverstärker verwendet werden, so gewählt ist, dass eine Länge der Drähte dem Wandler optimal Induktivität zur Verfügung stellt.

6. Ein integrierter Schaltkreis gemäß Anspruch 1, worin eine Dicke der Drähte, die zur Verbindung mit den Kontakten des Differenz-Leistungsverstärkers verwendet werden, gewählt ist, um dem Wandler optimal Induktivität zur Verfügung zu stellen.

7. Ein integrierter Schaltkreis gemäß Anspruch 1, worin Bahnen der Drähte, die zur Verbindung mit den Kontakten des Differentialleistungsverstärkers verwendet werden, erhöht oder gesenkt werden, um dem Wandler optimal Induktivität zur Verfügung zu stellen.

8. Ein integrierter Schaltkreis gemäß Anspruch 1, worin mehrere Drähte eine bestimmte Kontaktfläche und einen Stift der Kontakte des Differenz-Leistungsverstärkers verbinden, um eine Induktivität zwischen der Kontaktfläche und dem Stift durch Bilden mehrerer paralleler Induktoren zu verändern.

9. Ein Verfahren zur Umwandlung des Ausgangs eines Differenz-Leistungsverstärkers, der in den Chip eines integrierten Schaltkreises eingebettet ist, in ein unsymmetrisch Ausgangssignal, Folgendes umfassend:
Positionierung von Kontaktflächen auf dem Chip zur elektronischen Verbindung mit dem elektronischen Schaltkreis auf dem Chip,
Formen eines Gehäuses zur Umhüllung des Chips, wobei das Gehäuse Kontaktstifte zur Verbindung des integrierten Schaltkreises mit externen Elementen einschließt,
Verbindung von Drähten zwischen den Kontaktflächen und Kontaktstiften, die als Kontakte des Differenz-Leistungsverstärkers dienen,
Kombination der Ausgangssignale des Differenz-Leistungsverstärkers mit Hilfe von Kondensatoren und Induktoren, wobei die Kondensatoren zwischen dem Differenz-Leistungsverstärker und den Kontaktflächen in das Chips eingebettet sind,
wobei die Induktoren von den Drähten bereitgestellt werden, die die Verbindung zwischen den Kontaktflächen und den Stiften herstellen.

10. Ein Verfahren gemäß Anspruch 9, worin der Chip von einer Mitte des Gehäuses versetzt ist.

11. Ein Verfahren gemäß Anspruch 9, worin der Chip so in dem Gehäuse positioniert wird, dass eine Länge der Drähte optimiert wird, um Induktivität für den Wandler bereitzustellen.

12. Ein Verfahren gemäß Anspruch 9, worin die Kontaktstifte geformt werden durch Wegschneiden eines Innenumfangs eines metallischen Paddles (107), was die Kontaktstifte isoliert lässt, wobei der integrierte Schaltkreis auf das metallische Paddle platziert wird.

13. Ein Verfahren gemäß Anspruch 9, worin mehrere Drähte eine Verbindung zwischen einer spezifischen Kontaktfläche und einem Stift der Kontakte des Differenz-Leistungsverstärkers herstellen, um durch Bilden mehrerer paralleler Induktoren eine Induktivität zwischen der Kontaktfläche und dem Stift zu verändern.

14. Ein Verfahren gemäß Anspruch 9, worin Bahnen der Drähte, die zur Verbindung mit den Kontakten des DifferenzLeistungsverstärkers verwendet werden, erhöht oder gesenkt werden, um dem Wandler optimal Induktivität zur Verfügung zu stellen.

15. Ein integrierter Schaltkreis gemäß Anspruch 1, worin die Kontaktstifte geformt werden durch Wegschneiden eines Innenumfangs eines metallischen Paddles (107), was die Kontaktstifte isoliert lässt, wobei der integrierte Schaltkreis auf das metallische Paddle platziert wird.

## Revendications

1. Circuit intégré (100), comprenant :
une puce avec un circuit électronique intégré sur celle-ci ; dans lequel le circuit électronique comprend un amplificateur de puissance différentiel (115) et des pastilles (125, 126, 127) pour qu'elle s'interface électroniquement avec le circuit électronique ;
un boîtier (105) enfermant la puce avec des broches de contact (120, 121, 122) pour une connexion entre le circuit intégré et des éléments externes ;
des fils (130, 131, 132) pour une connexion entre les pastilles (125, 126, 127) et les broches de contact (120, 121, 122) ;
un convertisseur (150) qui comprend des condensateurs et des inductances pour combiner les signaux de sortie de l'amplificateur de puissance différentiel pour former un signal de sortie en mode commun au niveau de l'une des broches de contact ; dans lequel les condensateurs sont intégrés sur la puce entre l'amplificateur de puissance différentiel et les pastilles ;
dans lequel les inductances inhérentes de certains des fils (130, 131, 132) servent en tant qu'inductances du convertisseur.

2. Circuit intégré (100) selon la revendication 1, dans lequel la puce est décalée par rapport à un centre du boîtier.

3. Circuit intégré (100) selon la revendication 1, dans lequel la puce est positionnée dans le boîtier de sorte qu'une longueur des fils sera optimisée pour réaliser une inductance pour le convertisseur.

4. Circuit intégré (100) selon la revendication 1, dans lequel les positions de certaines des pastilles sur la puce ou des broches de contact sur le boîtier sont décalées pour provoquer l'extension ou le raccourcissement des fils effectuant la connexion entre elles.

5. Circuit intégré selon la revendication 1, dans lequel les désignations des broches de contact utilisées pour une connexion à l'amplificateur de puissance différentiel sont sélectionnées de sorte que les longueurs des fils réaliseront de manière optimale une inductance pour le convertisseur.

6. Circuit intégré selon la revendication 1, dans lequel une épaisseur des fils utilisés pour une connexion aux contacts de l'amplificateur de puissance différentiel est sélectionnée pour réaliser de manière optimale une inductance pour le convertisseur.

7. Circuit intégré selon la revendication 1, dans lequel les trajectoires des fils utilisés pour une connexion aux contacts de l'amplificateur de puissance différentiel sont élevées ou abaissées pour réaliser de manière optimale une inductance pour le convertisseur.

8. Circuit intégré selon la revendication 1, dans lequel de multiples fils effectuent une connexion entre une pastille spécifique et une broche des contacts de l'amplificateur de puissance différentiel pour modifier une inductance entre la pastille et la broche en formant de multiples inductances en parallèle.

9. Procédé de conversion de la sortie d'un amplificateur de puissance différentiel intégré sur la puce d'un circuit intégré en un signal de sortie en mode commun, comprenant :
le positionnement de pastilles sur la puce pour qu'elle s'interface électroniquement avec le circuit électronique sur la puce ;
la formation d'un boîtier pour enfermer la puce, dans lequel le boîtier comprend des broches de contact pour la connexion du circuit intégré à des éléments externes ;
la connexion de fils entre les pastilles et les broches de contact servant de contacts de l'amplificateur de puissance différentiel ;
la combinaison des signaux de sortie de l'amplificateur de puissance différentiel en utilisant des condensateurs et des inductances ; dans lequel les condensateurs sont intégrés sur la puce entre l'amplificateur de puissance différentiel et les pastilles ;
dans lequel les inductances sont réalisées par les fils réalisant la connexion entre les pastilles et les broches.

10. Procédé selon la revendication 9, dans lequel la puce est décalée par rapport à un centre du boîtier.

11. Procédé selon la revendication 9, dans lequel la puce est positionnée dans le boîtier de sorte qu'une longueur des fils sera optimisée pour réaliser une inductance pour le convertisseur.

12. Procédé selon la revendication 9, dans lequel les broches de contact sont formées en découpant une circonférence intérieure d'une palette métallique (107) en laissant les broches de contact isolées ; le circuit intégré est placé sur la palette métallique.

13. Procédé selon la revendication 9, dans lequel de multiples fils effectuent une connexion entre une pastille spécifique et une broche des contacts de l'amplificateur de puissance différentiel pour modifier une inductance entre la pastille et la broche en formant de multiples inductances en parallèle.

14. Procédé selon la revendication 9, dans lequel les trajectoires des fils utilisés pour une connexion aux contacts de l'amplificateur de puissance différentiel sont élevées ou abaissées pour réaliser de manière optimale une inductance pour le convertisseur.

15. Circuit intégré selon la revendication 1, dans lequel les broches de contact sont formées en découpant une circonférence intérieure d'une palette métallique (107) en laissant les broches de contact isolées ; le circuit intégré est placé sur la palette métallique.
